# DEMANDE DE BREVET EUROPEEN

(11) **EP 4 730 585 A1**
(43) Date de publication de la demande: **22.04.2026**
(21) Numéro de dépôt: 25209672.2
(22) Date de dépôt: 20.10.2025
(51) Int. Cl.: H02H 3/33

(54) **DISPOSITIF DE PROTECTION, ENSEMBLE DE PROTECTION, TABLEAU ÉLECTRIQUE ET MÉTHODE DE TEST ASSOCIÉS**

(30) Priorité: 21.10.2024 FR 2411461
(71) Demandeur: SCHNEIDER ELECTRIC INDUSTRIES SAS, 92500 Rueil-Malmaison (FR)
(72) Inventeur: TANGUY, Guillaume, 92500 Rueil Malmaison (FR); BORDET, Bruno, 92500 Rueil Malmaison (FR); WANG, Han, 92500 Rueil Malmaison (FR)
(74) Mandataire: Lavoix

(57) **Abrégé**

Ce dispositif de protection (300) comprend au moins deux chemins de conduction (303) et des moyens de coupure (310) agencés sur chacun des chemins de conduction. Le dispositif de comprend un microcontrôleur (320), qui est configuré pour mesurer un courant différentiel dans les chemins de conduction avec des moyens de détection (312), pour évaluer un défaut différentiel et pour envoyer aux moyens de coupure un signal de déclenchement lors de la détection d'un défaut différentiel du premier type. Le dispositif de protection (300) comprend également une boucle de test (360), qui est différente des moyens de détection. Le microcontrôleur (320) est configuré pour injecter, dans les chemins de conduction au moyen de la boucle de test, un premier signal test représentatif du défaut électrique du premier type et, conjointement, et pour mesurer, avec des moyens de détection, le premier signal de test ainsi injecté dans les chemins de conduction.

## Description

La présente invention concerne un dispositif de protection électrique, un ensemble de protection comprenant un tel dispositif de protection électrique, ainsi qu'un tableau électrique comprenant un tel dispositif de protection ou un tel ensemble de protection. L'invention concerne aussi une méthode de test d'un tel dispositif de protection.

On s'intéresse ici aux dispositifs de protection électrique aptes à détecter des défauts de courants différentiels, tels que les disjoncteurs différentiels. Il existe plusieurs types de défauts différentiels, qui sont définis notamment dans la norme IEC 60755:2017. En particulier, les types de défauts incluent le fait que le signal électrique soit redressé, que le signal inclut une composante à haute fréquence, le calibre - par exemple 30 mA ou 300 mA -... Les disjoncteurs différentiels sont en général configurés pour détecter un type spécifique de défaut différentiel. Lors de la fabrication, les dispositifs de protection sont testés, en usine, en injectant dans les chemins de conduction un signal de test représentatif du type de défaut considéré, de manière à vérifier le bon fonctionnement du disjoncteur différentiel.

Une fois que le dispositif de protection est mis en place au sein d'une installation électrique, par exemple dans un tableau électrique, pour vérifier que le disjoncteur fonctionne de manière satisfaisante, les disjoncteurs différentiels sont généralement équipés d'un bouton de test, qui permet d'injecter un courant représentatif dans des chemins de conduction du disjoncteur, de manière à déclencher volontairement le disjoncteur. Autrement dit, on vérifie que la chaine de détection - déclenchement est opérationnelle, mais il n'est plus possible de tester le disjoncteur avec un signal de test qui corresponde exactement au type de défaut considéré.

C'est à ces problèmes qu'entend plus particulièrement remédier l'invention, en proposant un dispositif de protection qui permette un test plus précis des défauts différentiels.

À cet effet, l'invention concerne un dispositif de protection électrique, qui est configuré pour relier une source de puissance à une charge électrique, le dispositif de protection comprenant :
- au moins deux chemins de conduction, incluant un premier chemin, qui est configuré pour être connecté à une phase de la source de puissance, et un deuxième chemin, qui est configuré pour être connecté soit à une autre phase de la source de puissance, soit à un neutre de la source de puissance, chaque chemin de conduction comprenant :
   - une borne d'arrivée, qui est configurée pour être connectée à une phase ou éventuellement au neutre de la source de puissance,
   - une borne de départ, qui est associée à la borne d'arrivée et qui est configurée pour être connectée à une borne de la charge électrique, et
   - des moyens de coupure qui sont configurés pour commuter entre une configuration armée, dans laquelle chaque borne d'arrivée est électriquement reliée à la borne de départ associée, et une configuration déclenchée, dans laquelle chaque borne d'arrivée est électriquement isolée de la borne de départ associée,
- des moyens de détection, qui incluent des boucles de mesure configurées pour mesurer un courant circulant dans chaque chemin de conduction,
- un microcontrôleur, qui est configuré pour :
   - évaluer la mesure de courant différentiel des moyens de détection à l'aide d'un premier filtre de détection, le premier filtre de détection étant préalablement enregistré dans une mémoire du microcontrôleur et étant adapté pour la détection d'un défaut différentiel d'un premier type, et
   - lors de la détection d'un défaut différentiel du premier type, envoyer aux moyens de coupure un signal de déclenchement, de manière à faire commuter les moyens de coupure de la configuration armée à la configuration déclenchée,
dans lequel :
- le dispositif de protection comprend une boucle de test, qui est différente de la boucle de mesure et qui est configurée pour injecter un signal électrique dans les chemins de conduction,
- le microcontrôleur est configuré :
   • pour injecter un premier signal test dans les chemins de conduction au moyen de la boucle de test, le premier signal test étant un signal électrique représentatif du défaut électrique du premier type et, conjointement,
   • pour mesurer, au moyen de la boucle de mesure, le premier signal de test injecté dans les chemins de conduction au moyen de la boucle de test.

Grâce à l'invention, les tests de déclenchement différentiels sont faits avec des signaux test qui remplissent exactement les mêmes critères des filtres de détection. Il est ainsi possible de vérifier de manière complète le bon fonctionnement de la chaine de détection, incluant la mesure, l'analyse des mesures, et le déclenchement des moyens de coupure. En outre, la chaine de détection, par laquelle la mesure est faite, est différente de la chaine de test, par laquelle le signal de test est injecté dans le circuit de conduction. On s'assure ainsi de la fiabilité de la mesure et du dispositif.

Selon des aspects avantageux mais non obligatoires de l'invention, un tel dispositif de protection peut incorporer une ou plusieurs des caractéristiques suivantes prises isolément ou selon toute combinaison techniquement admissible :
- Le microcontrôleur comprend un convertisseur numérique-analogique, une sortie analogique du convertisseur numérique-analogique étant connectée à la boucle de test,
   alors que chaque signal test est enregistré sous la forme d'un signal test numérique dans la mémoire du microcontrôleur,
   et que chaque signal test sous forme numérique est transformé, par le convertisseur numérique-analogique, en un signal analogique de la boucle de test, le signal analogique de la boucle de test étant le premier signal test.
- Le microcontrôleur est configuré pour détecter des défauts différentiels de plusieurs types différents, les plusieurs types incluant le premier type,
   alors qu'à chaque type de défaut différentiel correspond un filtre de détection respectif, le filtre de détection associé à chaque type de défaut différentiel étant préalablement enregistré dans la mémoire du microcontrôleur,
   et que le dispositif de protection comprend des moyens de communication, qui sont configurés pour la réception d'informations de configuration en provenance d'un dispositif distant du dispositif de protection, de manière à spécifier le ou les types de défauts différentiels pour lesquels, en cas de détection du défaut différentiel correspondant, le microcontrôleur envoie le signal de déclenchement aux moyens de coupure.
- Les plusieurs types de défauts différentiels incluent au moins un type de défaut différentiel défini par la norme IEC 60755:2017.
- À chaque type de défaut différentiel correspond un signal test respectif, le signal test associé à chaque type de défaut différentiel étant préalablement enregistré dans la mémoire du microcontrôleur,
   alors que pour chaque type de défaut différentiel considéré parmi les plusieurs types de défaut différentiel, le microcontrôleur est configuré pour injecter, dans les chemins de conduction, un signal de test correspondant, le signal de test correspondant étant un signal électrique représentatif du défaut électrique du type considéré.
- Le dispositif de protection comprend, outre les bornes d'arrivée et de départ, des bornes de transfert, qui sont prévues pour être connectées à un bus de transfert, le bus de transfert étant différent du bus de puissance, de manière à alimenter le microcontrôleur en énergie électrique indépendamment de la configuration, armée ou déclenchée, du mécanisme de commutation.
- Les moyens de communication sont configurés pour la recevoir les informations de configuration par l'intermédiaire des bornes de transfert et du bus de transfert.

L'invention concerne aussi un ensemble de distribution, qui comprend :
- un exemplaire du dispositif de protection tel que défini précédemment,
- un dispositif de distribution avec un bus de puissance,
dans lequel le dispositif de protection est monté sur le dispositif de distribution de manière réversible, les bornes d'entrée étant électriquement connectées au bus de puissance.

L'invention concerne également un tableau électrique, qui comprend :
- une enceinte présentant un fond,
- le dispositif de protection tel que défini précédemment, ou l'ensemble de distribution tel que défini précédemment,
dans lequel le dispositif de protection ou l'ensemble de distribution est fixé sur le fond de l'enceinte.

Selon un autre aspect, l'invention concerne une méthode de test d'un dispositif de protection électrique tel que défini précédemment, la méthode de test incluant :
- l'injection, dans les chemins de conduction et à l'aide de la boucle de test, d'un premier signal de test représentatif d'un défaut différentiel d'un premier type prédéterminé, des caractéristiques du défaut différentiel du premier type étant préalablement enregistrées dans une mémoire du microcontrôleur,
- pendant l'injection du premier signal de test, la mesure, dans les chemins de conduction et à l'aide de la boucle de mesure, d'un courant différentiel entre les chemins de conduction,
- la comparaison de la mesure de courant différentiel à un premier filtre de détection caractéristique du défaut différentiel du même type que le premier signal de test, le premier filtre de détection étant préalablement enregistré dans une mémoire du microcontrôleur, puis
- en résultat de la comparaison, la détermination d'un défaut différentiel correspondant au type de défaut différentiel considéré, puis si le résultat de la détermination est positif, l'envoi par le microcontrôleur d'un signal de déclenchement des moyens de coupure.

Cette méthode de test induit les mêmes avantages que ceux mentionnés ci-dessus au sujet du dispositif de protection de l'invention.

Avantageusement, la méthode de test inclut :
- préalablement à l'injection du premier signal de test dans les chemins de conduction, la réception d'informations de configuration, à l'aide des moyens de transmission, de manière à spécifier un type de défaut différentiel parmi plusieurs types de défauts différentiels préalablement enregistrés dans la mémoire du microcontrôleur, pour lesquels, en cas de détection du défaut différentiel correspondant, le microcontrôleur envoie le signal de déclenchement aux moyens de coupure,
- ensuite, lors de l'injection du premier signal de test dans les chemins de conduction, le premier signal de test correspond au type de défaut différentiel spécifié par les informations de configuration,
- ensuite, lors de la comparaison de la mesure de courant différentiel, le filtre de détection correspond au type de défaut différentiel spécifié.

L'invention sera mieux comprise, et d'autres avantages de celle-ci apparaîtront plus clairement à la lumière de la description qui va suivre d'un mode de réalisation d'un dispositif de protection, d'un ensemble de distribution, d'un tableau électrique et d'une méthode de test, conformes à son principe, donnée uniquement à titre d'exemple et faite en référence aux dessins annexés, dans lesquels :
- [Fig 1] la figure 1 est une vue en perspective partiellement éclatée un tableau électrique conforme à l'invention, le tableau électrique comprenant un ensemble de distribution avec au moins un dispositif de protection, aux-aussi conformes à l'invention ;

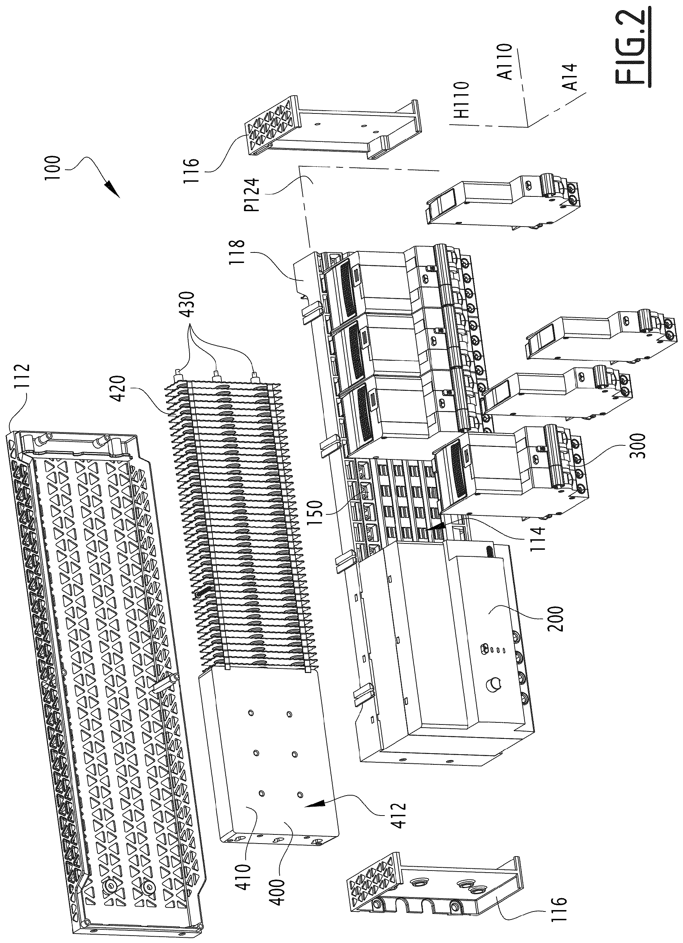

- [Fig 2] la figure 2 est une vue en perspective partiellement éclatée de l'ensemble de distribution de la figure 1 ;
- [Fig 3] la figure 3 représente respectivement, sur deux inserts a) et b), une vue en perspective de l'ensemble de distribution de la figure 1, certaines pièces étant cachées, et une vue en perspective d'un bus de transfert de l'ensemble de distribution,
- [Fig 4] la figure 4 est une vue en perspective partiellement éclatée de l'ensemble de distribution de la figure 1, certaines pièces étant cachées ;
- [Fig 5] la figure 5 est une représentation schématique de l'ensemble de distribution de la figure 1, et

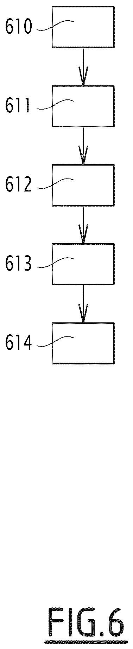

- [Fig 6] la figure 6 est un diagramme illustrant une méthode de test du dispositif de protection de la figure 1.

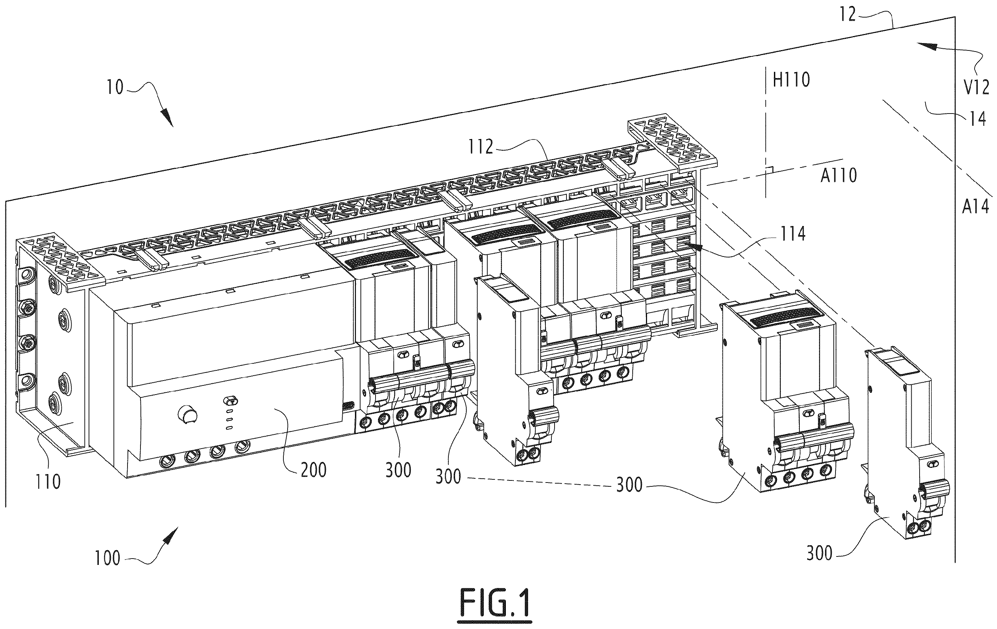

Un tableau électrique 10, conforme à l'invention, est représenté à la figure 1. Le tableau électrique 10 comprend un coffre 12, qui délimite une enceinte V12 et qui présente un fond 14. Le fond 14 s'étant globalement dans un plan orthogonal à un axe de profondeur A14. L'enceinte V12 est avantageusement refermée par une porte, qui n'est pas représentée.

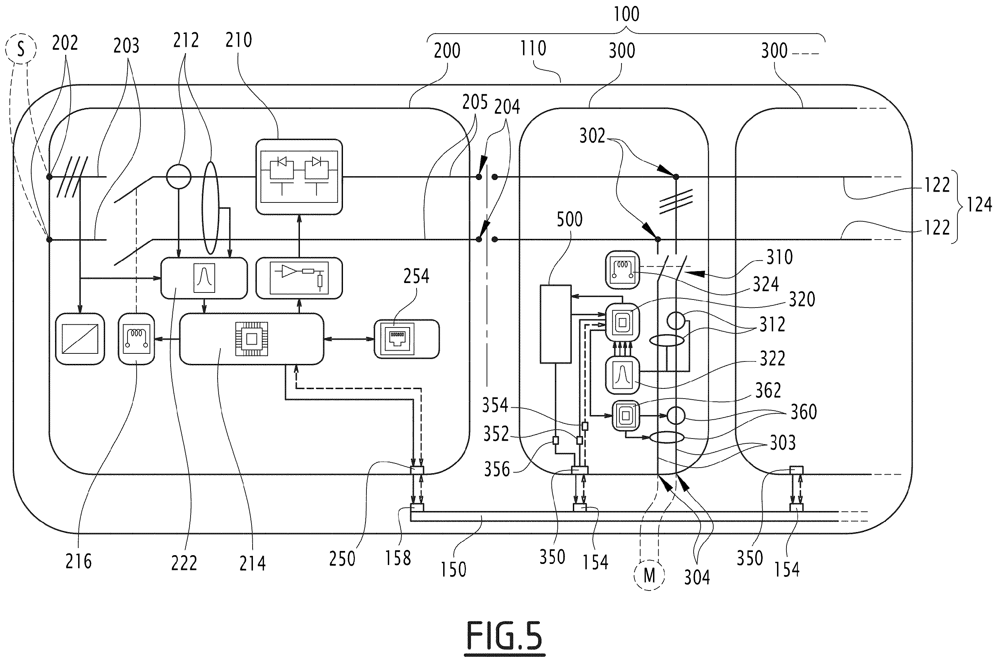

Le tableau électrique 10 comprend un ensemble de distribution 100. L'ensemble de distribution 100 est fixé sur le fond 14 du boitier 12. 1. L'ensemble de distribution 100 est configuré pour distribuer de l'énergie électrique provenant d'une source de puissance S à au moins une charge électrique M, par exemple un moteur. La source de puissance S et la charge électrique M, qui sont représentées schématiquement à la figure 5, ne font pas partie de l'invention mais servent à en expliquer le contexte de fonctionnement. La source de puissance S comprend un neutre et au moins une phase. Dans l'exemple illustré, la source de puissance S est une source triphasée, comprenant un neutre et trois phases. En variante non illustrée, la source de puissance S est monophasée, comprenant un neutre et une seule phase. Selon une autre variante, la source de puissance comprend trois phases, et pas de neutre.

L'ensemble de distribution 100 comprend avantageusement un dispositif de distribution 110, par lequel l'ensemble de distribution 100 est fixé sur le fond 14, un boitier principal 200, qui est assemblé au dispositif de distribution 110, de préférence de manière réversible, et au moins un dispositif de protection300, ici sept dispositifs de protection, chaque dispositif de protection300 étant assemblé au dispositif de distribution 110 de manière réversible, dans une position montée du dispositif de protection 300. Les dispositifs de protections 300 sont ici des boitiers de départ, les principes de l'invention étant bien entendu transposables à des dispositifs de protection d'un type différent. Il est ainsi possible de remplacer, au besoin, le boitier principal 200 en cas de dysfonctionnement du boitier principal 200, tout en conservant les autres éléments de l'ensemble de distribution 100, dispositif de distribution 110 et boitier(s) de départ 300, ce qui est économique. De même, il est possible de remplacer, au besoin, un ou plusieurs des dispositifs de protection 300, par exemple en cas de dysfonctionnement, tout en conservant les autres éléments, dispositif de distribution 110 et boitier principal 200, ce qui est économique.

Le dispositif de distribution 110 présente une forme allongée, qui s'étend selon un axe principal A110. Lorsque l'ensemble de distribution 100 est dans une configuration normale de fonctionnement, l'axe principal A110 est parallèle au fond 14, autrement dit orthogonal à l'axe de profondeur A14. De préférence, l'axe principal A110 est horizontal, comme illustré à la figure 1. On définit un axe de hauteur H110 comme étant un axe orthogonal à la fois à l'axe de profondeur A14 et à l'axe principal A110. La description est faite en regarde de l'orientation des dives éléments tels que représentés sur les figures, sachant qu'il peut en être autrement dans la réalité.

Dans l'exemple de la figure 1, le boitier principal 200 est situé sur la gauche de l'ensemble de distribution 100, les dispositifs de protection 300 étant situé sur la droite du boitier principal 200.

Lorsque l'ensemble de distribution 100 est fixé sur le fond 14, une portion arrière 112 du dispositif de distribution 110 est orientée en regard du fond 14, autrement dit orientée vers une direction arrière de l'ensemble de distribution 100. La direction arrière est ainsi parallèle à l'axe de profondeur A14. On définit également une direction avant comme étant une direction opposée à la direction arrière.

Le dispositif de distribution 110 présente ainsi une face de montage 114, qui est globalement orientée vers l'avant et qui est prévue pour le montage du boitier principal 200 et de chaque dispositif de protection 300.

La portion arrière 112 est réalisée en un matériau électriquement isolant, par exemple en polymère synthétique. La portion arrière 112 présente ici une forme globalement rectangulaire, qui s'étend dans sa plus grande dimension parallèlement à l'axe principal A110. Les petits côtés du rectangle sont ainsi parallèles à l'axe de hauteur H110. Le dispositif de distribution 110 comprend ici deux flasques 116, qui sont réalisés en un matériau électriquement isolant. Les deux flasques 116 sont assemblés aux petits côtés de la portion arrière 112 de manière à former un panier,

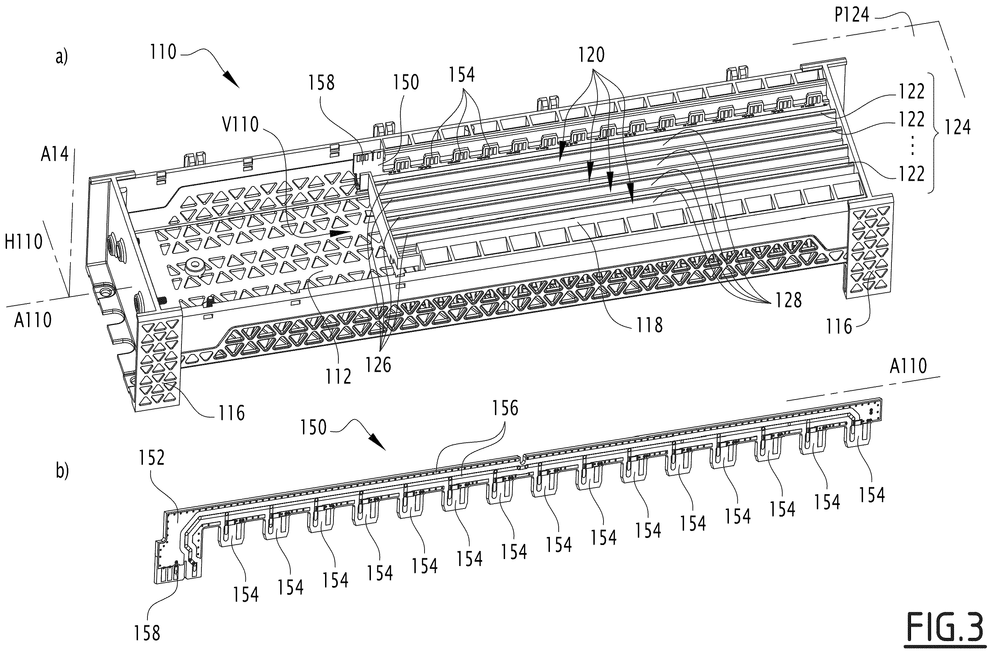

Le dispositif de distribution 110 comprend ici une paroi isolante 118, qui est réalisée en un matériau électriquement isolant et qui est assemblée à la portion arrière 112 et aux flasques 116, de manière à former une cavité V110, comme illustré à la figure 3.

Dans l'exemple illustré, le dispositif de distribution 110 comprend avantageusement un dispositif de refroidissement 400, qui est reçu dans la cavité V110 et qui est prévu pour évacuer une partie de la chaleur générée par le boitier principal 200 lorsque l'ensemble de distribution 100 est en fonctionnement. Le dispositif de refroidissement 400 est ainsi situé d'un côté arrière de la paroi isolante 118, tandis que d'un côté avant de la paroi isolante 118, le côté avant étant orienté à l'opposé du côté arrière, la paroi isolante 118 ménage des sillons 120 prévus pour recevoir plusieurs barres conductrices 122, ici quatre barres conductrices 122. Les barres conductrices 122 forment ensemble un bus de puissance 124 du dispositif de distribution 110 et, par extension, de l'ensemble de distribution 100. Le dispositif de distribution 110 est ainsi un dispositif de distribution de puissance.

Les barres conductrices 122 s'étendent parallèlement entre elles selon l'axe principal A110 de l'ensemble de distribution 100 et sont alignées selon l'axe de hauteur H110. Les barres conductrices 122 définissent ensemble un plan de connexion P124, qui est un plan orthogonal à l'axe de profondeur A14, autrement dit parallèle à l'axe de hauteur H110 et à l'axe principal A110. La face de montage 114 est globalement parallèle au plan de connexion P124.

Le dispositif de refroidissement 400 comprend une plaque de contact 410, qui est prévue pour capter une partie de la chaleur dégagée par le boitier principal 200, un radiateur 420, qui est prévu pour dissiper de la chaleur dans l'air ambiant, et au moins un caloduc 430, ici trois caloducs, qui relie la plaque de contact 410 au radiateur 420 et qui est configuré pour transférer au radiateur 420 une partie de la chaleur captée par la plaque de contact 410.

La plaque de contact 410 présente ici une forme de parallélépipède et présente une face de contact 412, qui s'étend parallèlement au plan de connexion P124. La face de contact 412 est configurée pour coopérer, notamment par complémentarité de formes, avec une face arrière 230 du boitier principal 200 en configuration montée sur le dispositif de distribution 110, de manière à favoriser le transfert thermique entre la plaque de contact 410 et le boitier principal 200.

Les barres conductrices 122 incluent au moins une barre de phase et, éventuellement, une barre de neutre, la barre de neutre étant associée au neutre de la source de puissance S, chaque barre de phase étant associée à une phase respective de la source de puissance S. Dans l'exemple illustré, le bus de puissance 124 comprend quatre barres conductrices 122, la source de puissance S étant une source triphasée avec un neutre. L'ensemble de distribution 100 présente ici une configuration dite « 3P+N », ou simplement 3PN.

En variante non représentée, la source de puissance S est triphasée, avec ou sans neutre, tandis que l'ensemble de distribution ne comprend pas de barre conductrice associée au neutre. Autrement dit, le bus de puissance 124 - et par extension l'ensemble de distribution 110 - ne comprend que trois barres de phases, chacune associée à une phase respective de la source de puissance S. L'ensemble de distribution est alors dans une configuration dite 3P. Plus généralement, le bus de puissance 124 est configuré pour être connecté à la source de puissance S.

Les principes de l'invention sont transposables quel que soit le nombre de phases de la source de puissance S. Selon une autre variante non illustrée, la source de puissance S est monophasée, c'est-à-dire ne comprend que le neutre et une seule phase. Les barres conductrices incluent alors une seule barre de phase, et la barre de neutre. L'ensemble de distribution est alors dans une configuration dite P+N, ou simplement PN. Quelles que soient les configurations, on a toujours plusieurs barres conductrices, qui incluent au moins une barre de phase, et éventuellement une barre de neutre.

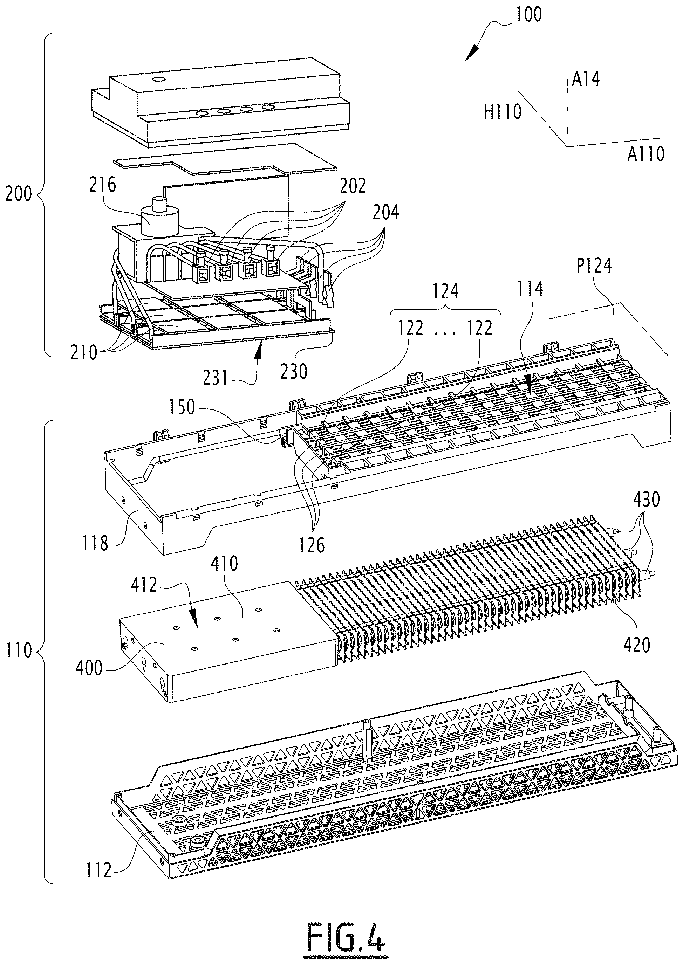

On décrit à présent le boitier principal 200, notamment en référence aux figures 4 et 5. Sur la figure 5, le circuit d'une seule phase est représenté, les trois phases étant représentées, selon une convention connue, par trois traits parallèles en travers du circuit.

Le boitier principal 200 comprend des bornes d'entrées 202, qui sont configurées pour être relié au neutre et à chaque phase de la source de puissance S, et des bornes de sorties 204, qui sont configurées pour être reliées aux barres conductrices, chaque borne de sortie étant associée à une barre conductrice respective et à une borne d'entrée respective. Les bornes d'entrée 202 sont ici des bornes à vis. Avantageusement, les bornes de sortie 204 sont des pinces de raccordement, qui sont chacune prévus pour la connexion réversible à une barre conductrice122 respective, selon un mouvement de connexion orienté vers l'arrière de l'ensemble de distribution 100. Ainsi, au cours du mouvement de à la connexion des bornes de sortie 204 aux barres conductrices 122, la face arrière du boitier principal 200 vient en appui contre la face de contact 412.

Pour chaque borne d'entrée 202, le boitier principal comporte une ligne d'entrée 203 correspondante, qui est reliée à la borne d'entrée 202 correspondante, et une ligne de sortie 205, qui est reliée à la borne de sortie 204 associée.

Le boitier principal 200 comprend des moyens de coupure principaux 210, qui sont commutables entre une configuration passante, dans laquelle chaque borne d'entrée 202 associée à une phase de la source de puissance S est électriquement reliée à la borne de sortie 204 associée, le boitier principal 200 étant dans une configuration passante, et une configuration de coupure, dans laquelle le passage d'un courant électrique entre la borne d'entrée 202 et la borne de sortie 204 associée est empêché, le boitier principal 200 étant dans une configuration de coupure.

Dans l'exemple préférentiel illustré, les moyens de coupure principaux 210 sont des moyens de coupures statiques, c'est-à-dire des interrupteurs de puissance base de composants semi-conducteurs, de préférence des transistors à effet de champ à grille isolée, appelés JFET ou MOSFET, et sont ainsi dits « statiques » par opposition aux moyens de coupure à contact mobile. Les moyens de coupure statiques 210 sont branchés en série entre la ligne d'entrée 203 et la ligne de sortie 205 associée. Les moyens de coupure statique 210 sont représentés schématiquement aux figures 4 et 5. En variante non représentée, les moyens de coupure principaux 210 sont des moyens de coupure électromécaniques à contacts séparables.

En fonctionnement, les moyens de coupure 210 dégagent de la chaleur, de l'ordre de quelques dizaines de Watts. Les moyens de coupure 210 sont avantageusement disposés de manière à favoriser le transfert d'au moins une partie de la chaleur dégagée vers le dispositif de refroidissement 400.

En particulier, les moyens de coupure 210 sont avantageusement agencés contre une paroi arrière 231 du boitier principal 200, de préférence en contact surfacique contre la paroi arrière 231. La paroi arrière 231 est par exemple présente lorsque le boitier principal 200 est démontable de la plaque de contact 410. La paroi arrière 231 ménage la face arrière 230, la face arrière 230 étant orientée à l'opposé des moyens de coupure 210. La paroi arrière 231 est ainsi intercalée entre les moyens de coupure 210 et la plaque de contact 410 lorsque la boitier principal 200 est monté sur le dispositif de distribution 110, de manière qu'une partie de la chaleur générée par les moyens de coupure 210 en fonctionnement est transférée à la plaque de contact 410 au travers de la paroi arrière.

La paroi arrière 231 est réalisée en un matériau thermiquement conducteur et électriquement isolant. Dans l'exemple illustré, la paroi arrière 231 est formée d'un assemblage d'un élément isolant 232, électriquement isolant, réalisé en matériau polymère synthétique, et d'une plaque de cuivre 233, qui apporte rigidité à l'ensemble tout en favorisant la conductivité thermique, la plaque de cuivre 233 ménageant la face arrière 230 et étant en appui contre la plaque de contact 410 lorsque le boitier principal 200 est monté sur le dispositif de distribution 110. En variante non illustrée, la plaque de cuivre 233 est omise, aussi la face arrière 230 est directement formée par l'élément isolant 232.

Le boitier principal 200 comprend des moyens de détection principaux 212, qui sont configurés pour mesurer des grandeurs électriques aux bornes de sortie et pour détecter un défaut électrique en fonction des valeurs mesurées. Les moyens de détection principaux 212 sont ici représentés schématiquement par des boucles de mesures, qui sont ici agencés sur les lignes de sortie 205. La représentation schématique des moyens de détection principaux ne limite pas le type de défauts électriques que les moyens de détection principaux 212 sont aptes à détecter.

Le boitier principal 200 est configuré pour passer de la configuration passante à la configuration de coupure lorsque les moyens de détection principaux 212 détectent un premier défaut électrique, par exemple un défaut différentiel ou un défaut de court-circuit.

Le boitier principal 200 comprend une unité de contrôle 214, ou ECU en anglais pour *Electronic Control Unit,* qui est configurée pour piloter les moyens de coupure statiques 210, autrement dit pour faire commuter les moyens de coupure statiques 210 entre la configuration passante et la configuration de coupure. L'unité de contrôle 214 est également configurée pour analyser les valeurs mesurées par les moyens de détection principaux 212 et pour déterminer, en fonction de critères prédéfinis correspondant à un type prédéterminé de défaut électrique, la présence d'un défaut électrique du type prédéterminé. À la figure 5, l'utilisation de critères prédéfinis est représentée schématiquement par la présence d'un filtre dit « primaire » 222, le filtre primaire 222 étant intercalé entre les moyens de détection principaux 212 et l'unité de contrôle 214.

Ainsi, les moyens de détection principaux 212 sont configurés pour détecter les défauts électriques de type courts-circuits. Par exemple, les moyens de détection principaux 212 incluent des capteurs de courant, en particulier un capteur de courant par phase, tandis l'unité de contrôle 214 est configurée pour analyser les mesures réalisées par les capteurs de courant et pour détecter un court-circuit.

De préférence, les moyens de détection principaux 212 incluent aussi un dispositif de détection de courant différentiel. Il existe plusieurs types de défauts différentiels, qui sont définis notamment dans la norme IEC 60755:2017. En particulier, les types de défauts électriques incluent le fait que le signal électrique soit redressé, que le signal inclut une composante à haute fréquence, le calibre - par exemple 30 mA ou 300 mA -... On comprend que le filtre primaire 222 définit des critères de détection des défauts électriques par l'unité de contrôle 214 du boitier principal 200. De préférence, le filtre primaire 222 définit des critères de détection d'un type de défaut différentiel prédéterminé, le défaut préférentiel prédéterminé étant choisi parmi les défauts définis dans la norme IEC 60755:2017.

De préférence, le boitier principal 202 comprend aussi, pour chaque borne d'entrée 202, un dispositif de coupure générale 216, qui est un dispositif de coupure à contacts séparables, ici un sectionneur. Le dispositif de coupure générale 216 est piloté par l'unité électronique de contrôle 214 et permet déconnecter électriquement la source de puissance S de l'ensemble de distribution 100, par exemple en cas de dysfonctionnement des moyens de coupure statiques 210. Le dispositif de coupure générale 216 est intercalé chaque borne d'entrée 202 et les moyens de coupure statiques 210.

Avantageusement, le dispositif de distribution 110, et par extension l'ensemble de distribution 100, comprend aussi un bus de transfert 150. Le bus de transfert 150, qui est représenté isolément à la figure 3 b), est prévu pour le fonctionnement pour alimenter en énergie chaque dispositif de protection 300 en position montée, c'est-à-dire connecté aux barres conductrices 122. Le bus de transfert 150 est donc ici un bus de transfert d'énergie, autrement dit un bus d'alimentation, qui est distinct du bus de puissance 124. Selon un exemple illustratif, le bus de transfert 150 fonctionne sous une tension de quelques dizaines de Volts, par exemple 50 V en continu, tandis que le bus de puissance 124 fonctionne sous une tension de 400 V en triphasé alternatif. Le bus de transfert 150 est ici une pièce distincte, qui est assemblée au reste du dispositif de distribution 110.

Le bus de transfert 150 comprend un corps 152, qui est réalisé en un matériau électriquement isolant, qui présente une forme allongée s'étendant le long du bus de puissance 124. Ainsi le bus de de transfert 150 s'étend le long de l'axe principal A110.

Le bus de transfert 150 définit plusieurs zones de montage 154, qui sont prévues pour être connectées à chaque dispositif de protection en position montée, les zones de montage 154 étant réparties, de préférence régulièrement, le long de l'axe principal A110 et étant chacune associée à une position unique le long de l'axe principal A110. Le bus de transfert 150 comprend préférentiellement quinze zones de montage 154, qui sont ici espacées les unes des autres d'un pas de 18 mm. D'autres pas sont bien entendu possibles. En variante non représentée, les zones de montages 154 sont espacées les unes des autres d'un pas de 9 mm.

Le bus de transfert 150 comprend au moins deux lignes de transfert 156, qui s'étendent le long du corps 152 est qui sont configurées pour être électriquement connectées à chaque dispositif de protection 300 en position montée. Les lignes de transfert 156 comprennent donc des lignes d'alimentation.

Le bus de transfert 150 comprend également une zone de connexion 158, qui est prévue pour la connexion du boitier principal 200 en position montée sur le dispositif de distribution 110. Par exemple, le boitier principal 200 comprend un bornier complémentaire 250, qui est configuré pour coopérer avec la zone de connexion 158, de sorte que le boitier principal est électriquement connecté aux lignes de transfert 156. Dans l'exemple préférentiel illustré, le boitier principal 200 prélève de l'énergie électrique nécessaire à l'alimentation du bus de transfert 150 sur le neutre et les phases de la source de puissance S, entre les moyens de coupure statique 210 et le dispositif de coupure générale 216, l'énergie électrique ainsi fournie étant à disposition des dispositifs de protection 300 pour leur fonctionnement, comme décrit plus loin.

Le bus de transfert 150 est ici réalisé par une carte de circuit imprimé, les lignes de transfert 156 étant des pistes conductrices ménagées en surface de la carte, tandis que les zones de montage 154 et la zone de connexion 158 sont des pattes ménagées dans le substrat de la carte. Dans l'exemple illustré, le bus de transfert 150 intègre avantageusement un bus de communication entre le boitier principal 200 et chaque dispositif de protection 300.

On décrit à présent les dispositifs de protection 300.

Chaque dispositif de protection 300 comprend ainsi un bornier d'arrivée qui est connectable aux barres conductrices 122 de manière réversible et qui comprend au moins deux bornes d'arrivée 302, chaque borne d'arrivée 302 étant configurée pout être électriquement connectée à une barre conductrice 122 respective. Pour chaque dispositif de protection 300, les bornes d'arrivée 302 qui incluent une borne d'arrivée neutre, qui est configurée pour être électriquement connectée à la barre neutre, et entre une et trois autres bornes d'arrivée, qui sont chacune configurées pour être connectée à une barre de phase respective. Chaque dispositif de protection 300 est configuré pour être monté, de manière réversible, sur le bus de puissance 114, de sorte que chaque borne d'arrivée 302 est électriquement reliée à la barre conductrice 122 correspondante.

Chaque dispositif de protection 300 comprend aussi un bornier de départ, qui est configuré pour être connecté à une charge électrique M respective et qui comprend des bornes de départ 304, chaque borne de départ 304 étant respectivement associée à une borne d'entrée 302 respective et étant reliée à cette borne d'entrée 302 par un chemin de conduction 303. Les bornes de départ 304 sont représentées schématiquement à la figure 5.

Dans l'exemple non limitatif illustré, les dispositifs de protections 300 présentent des largeurs différentes, la largeur étant mesurée selon l'axe principal **A110.** Ainsi les dispositifs de protections 300 sont ici répartis en deux sous-groupes, qui correspondent à deux largeurs différentes, avec des dispositifs de protections 300 fins et des dispositifs de protection 300 larges, qui sont sensiblement trois fois plus larges que les dispositifs de protection 300 fins. D'autres largeurs de dispositifs de protection 300 sont bien entendu envisageables. La largeur des dispositifs de protection 300 est de préférence un multiple du pas entre chaque zone de montage 154 du bus de transfert 150, soit ici 18 mm. En variante non représentée, les dispositifs de protection 300 ont une largeur égale à un multiple de 9 mm.

Dans l'exemple illustré, un dispositif de protection 300 configuré pour alimenter une charge électrique monophasée présente avantageusement une largeur de 18 mm, tandis qu'un dispositif de protection 300 configuré pour alimenter une charge électrique triphasée présente une largeur de trois fois 18 mm, soit 54 mm.

Les dispositifs de protections 300 les plus fins sont configurés pour être connectés à deux barres conductrices 122, incluant une barre neutre et une barre de phase, tandis que les dispositifs de protections 300 les plus larges sont configurés pour être connectés à quatre barres conductrices 122. Les principes de l'invention sont applicables quel que soit le nombre de phases auxquelles sont connectés chacun des dispositifs de protection 300.

De préférence, le dispositif de distribution 110 est prévu pour recevoir cinq dispositifs de protections 300, qui comprennent chacun quatre bornes d'arrivées, autrement dit cinq dispositifs de protections 300 larges. Selon un exemple non illustré, l'ensemble de distribution 100 comprend cinq dispositifs de protections 300, qui comprennent chacun quatre bornes d'arrivées 302. En corolaire, le dispositif de distribution 110 est également prévu pour recevoir quinze dispositifs de protections 300 fins comprenant chacun deux bornes d'arrivée 302.

Les barres conductrices 122 comprennent chacune :
- une portion d'alimentation 126, qui est configurée pour être connectée à une borne de sortie 204 associée du boitier principal 200 dans une configuration montée du boitier principal, et
- une portion de connexion 128, qui s'étend d'un même côté de la portion d'alimentation 126. Les portions de connexion 128 sont géométriquement situées d'un côté avant du plan de connexion P124 et définissent ensemble une zone de connexion du bus de puissance 124.

À la figure 4, seules les portions d'alimentation 126 des barres conductrices 122 sont visibles, les portions de connexion 128 étant cachées. La zone de connexion est configurée pour recevoir au moins un dispositif de protection 300, de sorte que le dispositif de protection est relié au bus de puissance 129. Le dispositif de protection 300 est alors propre à être connecté à une charge électrique, de manière à alimenter la charge électrique en puissance électrique.

Chaque dispositif de protection 300 comprend des moyens de coupure 310, qui sont intercalés entre chaque borne d'arrivée 302 et la borne de départ 304 correspondante. Les moyens de coupure 310 sont configurés pour commuter entre une configuration armée, dans laquelle chaque borne d'arrivée est électriquement reliée à la borne de départ associée, une configuration déclenchée, dans laquelle la borne d'arrivée est électriquement isolée de la borne de départ associée. Les moyens de coupure 310 sont ici formés par un mécanisme électromécanique à contacts séparables. La configuration armée des moyens de coupure 310 correspond donc ici à une position fermée des contacts mobiles, le dispositif de protection 300 concerné étant dans une configuration fermée, tandis que la configuration déclenchée des moyens de coupure 310 correspond à une position ouverte des contacts séparables, le dispositif de protection 300 concerné étant dans une configuration ouverte. En variante non représentée, les moyens de coupure 310 du dispositif de protection 300 sont des moyens de coupure statiques.

Chaque dispositif de protection 300 comprend des moyens de détection secondaires 312, qui sont configurés pour mesurer des grandeurs électriques aux bornes de départ correspondantes et pour détecter au moins un défaut électrique d'un type prédéterminé, c'est-à-dire correspondant à des critères de détection prédéterminés. En particulier, les moyens de détection secondaires 312 sont configurés pour mesurer un courant électrique circulant dans chaque chemin de conduction 303 Les moyens de détection secondaires 312 sont ici représentés schématiquement par des boucles de mesures, qui sont ici agencés sur les chemins de conduction 303 reliant les bornes d'arrivée 302 aux bornes de départ 304. La représentation schématique des moyens de détection secondaires 312 ne limite pas le type de défauts électriques que les moyens de détection secondaires sont aptes à détecter. Ainsi, les moyens de détection secondaires 312 sont configurés pour détecter les défauts électriques de type différentiel et, optionnellement, de type courts-circuits.

Par exemple, les moyens de détection secondaires 312 incluent des capteurs de courant, en particulier un capteur de courant par phase, tandis que le dispositif de protection 300 comprend un microcontrôleur 320, qui reçoit les mesures des capteurs de courant et qui est apte à déterminer si le ou les courants mesurés dépassent un seuil de court-circuit.

Le microcontrôleur 320 est alimenté par l'intermédiaire du bus de transfert 150. À cet effet, chaque dispositif de protection 300 comprend un bornier de transfert 350, qui comprend des bornes de transfert - non représentées -, le bornier de transfert 350 étant configuré pour être connecté au bus de transfert 150 de sorte que chaque borne de transfert est électriquement connectée à une ligne de transfert 156 respective. Le bornier de transfert 350 est donc ici un bornier d'alimentation. Les bornes de transfert sont différentes des bornes d'arrivée 302 ou des bornes de départ 304. Le dispositif de protection 300 comprend avantageusement une première unité d'alimentation 352, dite aussi « *Power supply unit »* ou PSU en anglais, qui est configurée pour recevoir de l'énergie électrique en provenance du bus de transfert 150, en particulier des lignes de transfert 156 dédiées à l'alimentation en énergie de fonctionnement, et pour alimenter le microcontrôleur 320 en énergie électrique de fonctionnement. Par extension, la première unité d'alimentation 352 est aussi configurée pour alimenter en énergie de fonctionnement les moyens de détection secondaires 312.

Avantageusement, le bus de transfert 150 sert aussi au transfert des données entre chaque microcontrôleur 320 et l'unité de contrôle 214 du boitier principal 200. Par exemple, le transfert d'information passe par les mêmes lignes de transfert 156 utilisées pour le transfert d'énergie. En alternative non illustrée, le bus de transfert 150 comprend des lignes de transfert d'information spécifiques, différentes des lignes de transfert 156 servant à l'alimentation. Les lignes de transfert d'information sont préférentiellement ménagées sur le bus de transfert 150.

Le dispositif de protection 300 comprend avantageusement des moyens de communication 354, qui sont configurés pour la réception d'informations en provenance d'un dispositif distant du dispositif de protection 300. Dans l'exemple illustré, les moyens de communication 354 sont distincts du microcontrôleur 320. En variante non illustrée, les moyens de communication 354 sont intégrés au microcontrôleur 320.

Les moyens de communication 354 sont avantageusement configurés pour la recevoir des informations par l'intermédiaire des bornes de transfert 350 et du bus de transfert 150. Dans l'exemple préférentiel illustré, le dispositif de protection 300 est configuré pour recevoir des informations en provenance du boitier principal 200, qui constitue un premier exemple de dispositif distant. Dans l'exemple illustré, le boitier principal 200 comprend des moyens principaux de communication 254, qui sont ici représentés par une prise au format RJ45 et qui sont prévus pour qu'un utilisateur puisse configurer le boitier principal 200 et, plus généralement, l'ensemble de distribution 100. Selon un exemple avantageux d'utilisation, pour chaque type de charge électrique connectée aux bornes de départ 304, la configuration du dispositif de protection 300 est adaptée en conséquence, de manière à offrir la protection la plus adaptée contre les défauts différentiels.

En variante non illustrée, les moyens de communication 354 du dispositif de protection 300 comprennent une prise de connexion, par exemple une prise au format RJ45, pour la réception d'informations. Dans ce cas, les informations ne transitent pas par le bus de transfert 150. Selon une autre variante non illustrée, les moyens de communications 354 du dispositif de protection 300 et/ou les moyens principaux de communication 254 du boitier principal 200 sont des moyens sans fils.

Dans l'exemple illustré, le dispositif de protection 300 comprend avantageusement un circuit de supervision 500 et une deuxième unité d'alimentation 356. Le circuit de supervision 500 est prévu pour superviser le bon fonctionnement du microcontrôleur 320. La deuxième unité d'alimentation 356 est différente de la première unité d'alimentation 352 et est prévue pour recevoir de l'énergie électrique en provenance du bus de transfert 150 et pour alimenter en énergie de fonctionnement le circuit de supervision 500. Ces aspects ne sont pas détaillés plus avant dans le cadre de la présente description.

Les moyens de détection secondaires 312 incluent un dispositif de détection de courant différentiel, par exemple une boucle de mesure, configurée pour mesurer un courant différentiel. Le microcontrôleur 320 est ainsi configuré pour évaluer la mesure de courant différentiel à l'aide d'un filtre de détection 322, le filtre de détection 322 étant préalablement enregistré dans une mémoire du microcontrôleur 320 du dispositif de protection 300 et étant adapté pour la détection d'un défaut différentiel d'un premier type. Par « évaluer la mesure de courant différentiel à l'aide du filtre de détection 322 », on entend que le filtre de détection 322 est appliqué au signal du courant différentiel mesuré par les moyens de détection secondaires 312, de manière à en extraire une signature caractéristique, ladite signature caractéristique étant ensuite comparée, par le microcontrôleur 320, à un critère préalablement enregistré dans la mémoire du microcontrôleur 320.

On comprend que le filtre secondaire 322 définit les critères de détection des défauts électriques détectés par le microcontrôleur 320 du dispositif de protection 300. À chaque type de défaut électrique donné correspond donc un filtre secondaire 322 spécifique. De préférence, le filtre secondaire 322 définit des critères de détection d'un type de défaut différentiel prédéterminé, qui est choisi parmi les défauts définis dans la norme IEC 60755:2017.

Chaque microcontrôleur 320 est alimenté en énergie électrique de fonctionnement par l'intermédiaire du bus de transfert 150, indépendamment de la configuration, armée ou déclenchée, des moyens de coupure 310.

Chaque dispositif de protection 300 comprend ici un actionneur 324, qui est configuré pour déplacer les moyens de coupure électromécaniques 310 dans la position ouverte lorsque l'actionneur 324 reçoit un signal de déclenchement, le microcontrôleur 320 étant configuré pour envoyer à l'actionneur 324 le signal de déclenchement lors de la détection d'un défaut électrique, notamment un défaut de court-circuit ou un défaut différentiel. Plus généralement, chaque dispositif de protection 300 est configuré pour passer de la configuration fermée à la configuration ouverte lorsque les moyens de détection secondaires 312 - et par extension le microcontrôleur 320 - détectent un défaut électrique.

Selon un aspect de l'invention, le dispositif de protection 300 comprend une boucle de test 360, qui est différente de la boucle de mesure des moyens secondaires de détection 312 et qui est prévue pour injecter un signal électrique dans les chemins de conduction 303. Dans l'exemple illustré, le microcontrôleur 320 est configuré pour injecter, au moyen de la boucle de test 360, un premier signal test dans les chemins de conduction 303, le premier signal test étant un signal électrique représentatif du défaut électrique du premier type. Conjointement, le microcontrôleur 320 est configuré pour mesurer, au moyen de la boucle de mesure 312, le premier signal de test injecté dans les chemins de conduction 303 au moyen de la boucle de test 360.

Ainsi, il est possible d'injecter dans les circuits de conduction 303, à l'aide de la boucle de test 360, un signal test représentant un défaut électrique différentiel d'un type spécifique, et de vérifier que la détection de ce le défaut électrique spécifique ainsi injecté est bien réalisée, au moyen de la boucle de mesure 312, combinée au filtre de détection 322 et au microcontrôleur 320. On vérifie ainsi l'ensemble de la chaine de détection du dispositif de protection 300, et ce spécifiquement pour le type de défaut différentiel considéré. Cette vérification est possible lorsqu'aucune charge électrique n'est connectée au dispositif de protection 300 considéré.

De préférence, chaque premier signal de test est enregistré sous la forme d'un signal test numérique dans la mémoire du microcontrôleur 320, tandis que le premier signal test injecté par la boucle de test 360 est un signal analogique. Le microcontrôleur 320 comprend ainsi un convertisseur numérique-analogique 362, qui est configuré pour transformer chaque signal test sous forme numérique en un signal analogique de la boucle de test. Dans l'exemple schématique illustré, le convertisseur numérique analogique 362 est séparé du microcontrôleur 320 et est interposé entre le microcontrôleur 320 et la boucle de test 360 et comprend une entrée numérique, qui est connectée à une sortie du microcontrôleur 320, et une sortie analogique, qui est connectée à la boucle de test 360. En variante non représentée, le convertisseur numérique / analogique 362 est intégré au reste du microcontrôleur 360, par exemple dans un même circuit intégré ou au sein d'une même carte électronique.

Avantageusement, le microcontrôleur 320 est configuré pour détecter des défauts différentiels de plusieurs types différents. À chaque type de défaut différentiel correspond un filtre de détection 322 respectif, le filtre de détection 322 associé à chaque type de défaut différentiel étant préalablement enregistré dans la mémoire du microcontrôleur 320.

Les moyens de communication 354 du dispositif de protection 300 sont avantageusement configurés pour la réception d'informations de configuration en provenance d'un dispositif distant du dispositif de protection, de manière à spécifier le ou les types de défauts différentiels pour lesquels, en cas de détection du défaut différentiel correspondant, le microcontrôleur envoie à l'actionneur le signal de déclenchement. Autrement dit, le microcontrôleur 320 est configurable à distance, les informations de configurations incluant le type de défaut électrique contre lequel le dispositif de protection 300 doit protéger. Ainsi, les informations de configurations servent à spécifier le filtre de détection 322 particulier qui doit être mis en œuvre pour la détection d'un défaut différentiel spécifique. Selon les cas, plusieurs filtres de détection 322 sont préalablement enregistrés dans la mémoire du microcontrôleur 320, et les informations de configurations spécifient lequel des filtres de détection 322 doit être activé pour la détection des défauts électriques. Alternativement, un seul filtre de détection 322 est enregistré dans la mémoire du microcontrôleur 320, et les informations de configuration contiennent le nouveau filtre de détection, qui est enregistré à la place du filtre de détection précédent.

De manière symétrique, à chaque type de défaut différentiel correspond un signal de test spécifique. Lorsqu'un nouveau de filtre de détection 322 est spécifié par les informations de configuration, il convient également de spécifier un nouveau signal de test qui corresponde au même type de défaut électrique que le nouveau filtre de détection. Pour chaque type de défaut différentiel considéré parmi les plusieurs types de défaut différentiel, le microcontrôleur 320 est configuré pour injecter, dans les chemins de conduction 303, un signal de test correspondant, qui est un signal électrique représentatif du défaut électrique du type considéré.

Selon les cas, plusieurs signaux test sont préalablement enregistrés, sous forme numérique, dans la mémoire du microcontrôleur 320, et les informations de configurations spécifient lequel des signaux tests doit être activé pour vérifier le bon fonctionnement de la chaine de détection, en particulier vérifier que le bon filtre de détection 322 est activé. Alternativement, un seul signal de test est enregistré dans la mémoire du microcontrôleur 320, et les informations de configuration contiennent le nouveau signal de test, qui est enregistré à la place signal de test précédent.

Ainsi, le dispositif de protection 300 tel que décrit précédemment est configuré pour mettre en œuvre une méthode de test qui inclut :
- une étape 611 d'injection, dans les chemins de conduction 303 et à l'aide de la boucle de test 360, d'un premier signal de test représentatif d'un défaut différentiel d'un premier type prédéterminé, des caractéristiques du défaut différentiel du premier type étant préalablement enregistrées dans une mémoire du microcontrôleur,
- pendant l'injection du premier signal de test, une étape 612 de mesure, dans les chemins de conduction 303 et à l'aide de la boucle de mesure 312, d'un courant différentiel entre les chemins de conduction 303,
- une étape 613 de comparaison de la mesure de courant différentiel à un premier filtre de détection 322 caractéristique du défaut différentiel du même type que le premier signal de test, le premier filtre de détection étant préalablement enregistré dans une mémoire du microcontrôleur 320, puis
- en résultat de l'étape 613 de comparaison, une étape 614 de détermination d'un défaut différentiel correspondant au type de défaut différentiel considéré.

Par « comparaison de la mesure de courant différentiel à un premier filtre de détection 322 », on entend qu'au cours de l'étape 613, on applique le premier filtre de détection 322 au courant différentiel mesuré lors de l'étape 612 pour en extraire une signature caractéristique, ladite signature caractéristique étant ensuite évaluée au cours de l'étape 614 de détermination, de manière à déterminer le défaut différentiel correspondant au type de défaut différentiel considéré.

Par exemple, si le résultat de l'étape de détermination 614 est positif, le microcontrôleur 320 envoie à l'actionneur 324 un signal de déclenchement des moyens de coupure 310.

Avantageusement, préalablement à l'injection du premier signal de test dans les chemins de conduction, la méthode de test inclut :
- une étape 610 de réception d'informations de configuration, à l'aide des moyens de transmission 354, de manière à spécifier un type de défaut différentiel parmi plusieurs types de défauts différentiels préalablement enregistrés dans la mémoire du microcontrôleur, pour lesquels, en cas de détection du défaut différentiel correspondant, le microcontrôleur envoie aux moyens de coupure 310 - ici à l'actionneur 324 un signal de déclenchement.

Ensuite, lors de l'étape 611 d'injection du premier signal de test dans les chemins de conduction, le premier signal de test correspond au type de défaut différentiel spécifié préalablement par les informations de configuration au cours de l'étape 610 de réception d'informations de configuration.

Au cours de l'étape 613 de comparaison de la mesure de courant différentiel, le filtre de détection correspond au type de défaut différentiel spécifié préalablement par les informations de configuration au cours de l'étape 610 de réception d'informations de configuration.

Avantageusement, les résultats du test sont transmis à l'utilisateur, par exemple les résultats sont transmis au boitier principal 200, par l'intermédiaire du bus de transfert 150. Il est ainsi possible de tester individuellement chacun des dispositifs de protection 300 qui sont montés sur le dispositif de distribution 110.

Les modes de réalisation et les variantes mentionnées ci-dessus peuvent être combinés entre eux pour générer de nouveaux modes de réalisation de l'invention.

## Revendications

1. Dispositif de protection (300) électrique, configuré pour relier une source de puissance (S) à une charge électrique (M), le dispositif de protection (300) comprenant :
- au moins deux chemins de conduction (303), incluant un premier chemin, qui est configuré pour être connecté à une phase de la source de puissance (S), et un deuxième chemin, qui est configuré pour être connecté soit à une autre phase de la source de puissance (S), soit à un neutre de la source de puissance (S), chaque chemin de conduction (303) comprenant :
• une borne d'arrivée (302), qui est configurée pour être connectée à une phase ou éventuellement au neutre de la source de puissance (S),
• une borne de départ (304), qui est associée à la borne d'arrivée (302) et qui est configurée pour être connectée à une borne de la charge électrique (M), et
• des moyens de coupure (310), qui sont configurés pour commuter entre une configuration armée, dans laquelle chaque borne d'arrivée (302) est électriquement reliée à la borne de départ (304) associée, et une configuration déclenchée, dans laquelle chaque borne d'arrivée (302) est électriquement isolée de la borne de départ (304) associée,
- des moyens de détection (312), qui incluent des boucles de mesure configurées pour mesurer un courant circulant dans chaque chemin de conduction (303),
- un microcontrôleur (320), qui est configuré pour :
• évaluer la mesure de courant différentiel des moyens de détection (312) à l'aide d'un premier filtre de détection (322), le premier filtre de détection (322) étant préalablement enregistré dans une mémoire du microcontrôleur (320) et étant adapté pour la détection d'un défaut différentiel d'un premier type, et
• lors de la détection d'un défaut différentiel du premier type, envoyer aux moyens de coupure (310) un signal de déclenchement, de manière à faire commuter les moyens de coupure (310) de la configuration armée à la configuration déclenchée,
dans lequel :
- le dispositif de protection (300) comprend une boucle de test (360), qui est différente de la boucle de mesure et qui est configurée pour injecter un signal électrique dans les chemins de conduction (303),
- le microcontrôleur (320) est configuré :
• pour injecter un premier signal test dans les chemins de conduction (303) au moyen de la boucle de test (360), le premier signal test étant un signal électrique représentatif du défaut électrique du premier type et, conjointement,
• pour mesurer, au moyen de la boucle de mesure (312), le premier signal de test injecté dans les chemins de conduction (303) au moyen de la boucle de test.

2. Dispositif de protection (300) selon la revendication 1, dans lequel :
- le microcontrôleur (320) comprend un convertisseur numérique-analogique (362), une sortie analogique du convertisseur numérique-analogique étant connectée à la boucle de test (360),
- chaque signal test est enregistré sous la forme d'un signal test numérique dans la mémoire du microcontrôleur (320),
- chaque signal test sous forme numérique est transformé, par le convertisseur numérique-analogique (362), en un signal analogique de la boucle de test, le signal analogique de la boucle de test étant le premier signal test.

3. Dispositif de protection (300) selon l'une quelconque des revendications 1 ou 2, dans lequel :
- le microcontrôleur (320) est configuré pour détecter des défauts différentiels de plusieurs types différents, les plusieurs types incluant le premier type,
- à chaque type de défaut différentiel correspond un filtre de détection (322) respectif, le filtre de détection (322) associé à chaque type de défaut différentiel étant préalablement enregistré dans la mémoire du microcontrôleur (320),
- le dispositif de protection (300) comprend des moyens de communication (354), qui sont configurés pour la réception d'informations de configuration en provenance d'un dispositif distant (200) du dispositif de protection (300), de manière à spécifier le ou les types de défauts différentiels pour lesquels, en cas de détection du défaut différentiel correspondant, le microcontrôleur (320) envoie le signal de déclenchement aux moyens de coupure (310).

4. Dispositif de protection (300) selon la revendication 3, dans lequel :
- les plusieurs types de défauts différentiels incluent au moins un type de défaut différentiel défini par la norme IEC 60755:2017.

5. Dispositif de protection (300) selon l'une quelconque des revendications 3 ou 4, dans lequel :
- à chaque type de défaut différentiel correspond un signal test respectif, le signal test associé à chaque type de défaut différentiel étant préalablement enregistré dans la mémoire du microcontrôleur (320),
- pour chaque type de défaut différentiel considéré parmi les plusieurs types de défaut différentiel, le microcontrôleur (320) est configuré pour injecter, dans les chemins de conduction (303), un signal de test correspondant, le signal de test correspondant étant un signal électrique représentatif du défaut électrique du type considéré.

6. Dispositif de protection (300) selon l'une quelconque des revendications 3 à 5, dans lequel :
- le dispositif de protection (300) comprend, outre les bornes d'arrivée (302) et de départ, des bornes de transfert (350), qui sont prévues pour être connectées à un bus de transfert (150), de manière à alimenter le microcontrôleur (320) en énergie électrique indépendamment de la configuration, armée ou déclenchée, du mécanisme de commutation (310).

7. Dispositif de protection (300) selon la revendications 6, dans lequel :
- les moyens de communication (354) sont configurés pour la recevoir les informations de configuration par l'intermédiaire des bornes de transfert (350) et du bus de transfert (150).

8. Ensemble de distribution (100), comprenant :
- un exemplaire du dispositif de protection (300) selon l'une quelconque des revendications 1 à 7,
- un dispositif de distribution (110) avec un bus de puissance (124),
dans lequel :
- le dispositif de protection (300) est monté sur le dispositif de distribution (110) de manière réversible, les bornes d'entrée (302) étant électriquement connectées au bus de puissance (124).

9. Tableau électrique (10), comprenant :
- une enceinte (12) présentant un fond (14),
- le dispositif de protection (300) selon l'une quelconque des revendications 1 à 7, ou l'ensemble de distribution selon la revendication 8,
dans lequel :
- le dispositif de protection (300) ou l'ensemble de distribution (110) est fixé sur le fond de l'enceinte.

10. Méthode de test d'un dispositif de protection (300) électrique, le dispositif de protection (300) étant conforme à l'une quelconque des revendications 1 à 7, la méthode de test incluant :
- l'injection (611), dans les chemins de conduction (303) et à l'aide de la boucle de test, d'un premier signal de test représentatif d'un défaut différentiel d'un premier type prédéterminé, des caractéristiques du défaut différentiel du premier type étant préalablement enregistrées dans une mémoire du microcontrôleur (320),
- pendant l'injection du premier signal de test, la mesure (612), dans les chemins de conduction (303) et à l'aide de la boucle de mesure, d'un courant différentiel entre les chemins de conduction (303),
- la comparaison (613) de la mesure de courant différentiel à un premier filtre de détection (322) caractéristique du défaut différentiel du même type que le premier signal de test, le premier filtre de détection étant préalablement enregistré dans une mémoire du microcontrôleur (320), puis
- en résultat de la comparaison, la détermination (614) d'un défaut différentiel correspondant au type de défaut différentiel considéré, puis si le résultat de la détermination est positif, l'envoi par le microcontrôleur (320) d'un signal de déclenchement des moyens de coupure (310).

11. Méthode de test selon la revendication 10, incluant :
- préalablement à l'injection (611) du premier signal de test dans les chemins de conduction (303), la réception (610) d'informations de configuration, à l'aide des moyens de transmission (354), de manière à spécifier un type de défaut différentiel parmi plusieurs types de défauts différentiels préalablement enregistrés dans la mémoire du microcontrôleur (320), pour lesquels, en cas de détection du défaut différentiel correspondant, le microcontrôleur (320) envoie le signal de déclenchement aux moyens de coupure (310),
- ensuite, lors de l'injection (611) du premier signal de test dans les chemins de conduction (303), le premier signal de test correspond au type de défaut différentiel spécifié par les informations de configuration,
- ensuite, lors de la comparaison (612) de la mesure de courant différentiel, le filtre de détection (322) correspond au type de défaut différentiel spécifié.
